# EUROPÄISCHE PATENTANMELDUNG

(11) **EP 0 547 312 A1**
(43) Veröffentlichungstag der Anmeldung: **23.06.1993**
(21) Anmeldenummer: 92117086.6
(22) Anmeldetag: 07.10.1992
(51) Int. Cl.: C23C 14/50, G02C 13/00

(54) **Substrathalte- und Wendevorrichtung für Vakuumprozesse**

(30) Priorität: 19.12.1991 CH 3790/91
(71) Anmelder: BALZERS AKTIENGESELLSCHAFT, FL-9496 Balzers (LI)
(72) Erfinder: Thiebaud, Francis, Dr.Dipl.Phys., CH-9479 Oberschan (CH); Stingl, Friedrich, Li - 9496 Balzers (LI)
(74) Vertreter: Troesch Scheidegger Werner AG

(57) **Zusammenfassung**

Um Substrate, wie Linsen, mit unterschiedlicher Grösse in einer Bearbeitungsanlage anzuordnen, umfasst eine Haltevorrichtung eine Federspange (3), vorgesehen zum einspannenden Halten der Substrate bzw Linsen, welche Federspange geeignet ist für das Anordnen in einer Halterung (9) der Vorrichtung.

## Beschreibung

Die vorliegende Erfindung betrifft eine Vorrichtung zum Halten von Substraten für die Bearbeitung mit Vakuumverfahren, wie Linsen, mit unterschiedlicher Grösse sowie einen Mehrfachsubstrathalter mit einer Vielzahl von Vorrichtungen.

In der Sparte Substrathaltevorrichtungen, wie beispielsweise Glaslinsen-Halteringe, sowie Substratwendehalter für Beschichtungsanlagen sind die verschiedensten Ausführungen bekannt. Aus dem Stand der Technik sind die CH-PS-631 638, 659 485, die EP-A-0 215 261, die DE-OS-35 13 137, 39 21 671 sowie die DE-A-37 15 831 bekannt.

Im zitierten Stand der Technik werden entweder Ein- oder Mehrfachsubstrathalter vorgeschlagen, mittels welcher relativ schnell Substrate im Kalter ausgewechselt werden können und gegebenenfalls Substrate, wie beispielsweise optische Linsen, mit unterschiedlichen Dimensionen angeordnet werden können. Auch wird in einem Teil des Standes der Technik vorgeschlagen, eine Wendevorrichtung vorzusehen, damit die Substrate, wie beispielsweise optische Linsen, in der Halterung zwecks beidseitiger Beschichtung gewendet werden können.

Die Aufgabe der vorliegenden Erfindung besteht darin, ebenfalls eine Substrathaltevorrichtung vorzuschlagen, in welcher auf schnelle und einfachste Art und Weise Substrate, wie beispielsweise die erwähnten optischen Linsen, mit unterschiedlichen Dimensionen angeordnet bzw. ausgewechselt werden können. Eine weitere Aufgabe besteht darin, die Vorrichtung derart auszubilden, dass sie in einer entsprechenden Wendevorrichtung angeordnet werden kann, um Substrate beidseitig, d.h. nacheinander je von einer Seite bearbeiten zu können, ohne die Vakuumprozesskammer für ein manuelles Wenden öffnen zu müssen.

Erfindungsgemäss werden die gestellten Aufgaben mittels einer Vorrichtung zum Halten von Substraten, wie Linsen, mit unterschiedlicher Grösse gemäss den Wortlaut nach Anspruch 1 gelöst.

Vorgeschlagen wird eine Vorrichtung, umfassend eine äussere Halterung, wie beispielsweise einen Tragring, und eine innere, in der Halterung anzuordnende, einseitig offene Federspange, die vorgesehen ist zum umgreifenden, einspannenden Halten eines flächigen Substrates, wie einer Linse. Je nach der peripheren Kontur des flächigen Substrates ist die Federspange beispielsweise eckig, oval oder wenigstens nahezu kreisrund ausgebildet und weist je an einem Spangenende ein Halteelement auf für das Einspannen des Substrates.

Die Federspange umfasst vorzugsweise im Bereich gegenüberliegend zur Oeffnung der Spange mindestens ein Lagerelement bzw. eine Abstützung, um die Federspange zusammen mit dem oder den Halteelement(en) in entsprechenden Aufnahmen in oder an der Halterung zu lagern.

Die Aufnahmen für das oder die Halteelement(e) umfassen vorzugsweise mehrere Einrastpositionen, um die Federspange je nach Substratgrösse unterschiedlich spannen zu können.

Weitere bevorzugte Ausführungsvarianten der erfindungsgemässen Vorrichtung sind in den Unteransprüchen 2 bis 10 charakterisiert.

Die oben erwähnten erfindungsgemässen Vorrichtungen eignen sich insbesondere für das Anordnen in einer Bearbeitungskammer und gegebenenfalls auf einem Mehrfachsubstrathalter, vorgesehen für das ein- oder beidseitige Behandeln bzw. Beschichten von optischen Substraten, wie Linsen, Spiegel, Filter und dergleichen. Bevorzugte Ausführungen von Mehrfachsubstrathaltern sind in den Ansprüchen 11 und 12 charakterisiert.

Die Erfindung wird nun beispielsweise und unter Bezug auf die beigefügten Figuren näher erläutert.

Dabei zeigen:
- Fig. 1: eine Draufsicht auf eine erfindungsgemässe Haltevorrichtung mit einer eingespannten Linse,
- Fig. 2: die Spange von Fig. 1,
- Fig. 3: einen Schnitt durch die Haltevorrichtung von Fig. 1 entlang der Linie I-I,
- Fig. 4: in Draufsicht die Haltevorrichtung von Fig. 1, weiter umfassend eine Wendevorrichtung,
- Fig. 5: die Haltevorrichtung von Fig. 4, gesehen von vorn in Pfeilrichtung A,
- Fig. 6: in Draufsicht dargestellt eine Substrathalterung, angeordnet in einem flächigen Halteorgan,
- Fig. 7: einen Mehrfachsubstrathalter und
- Fig. 8: einen weiteren Mehrfachsubstrathalter, angeordnet in einer Aufdampfanlage.

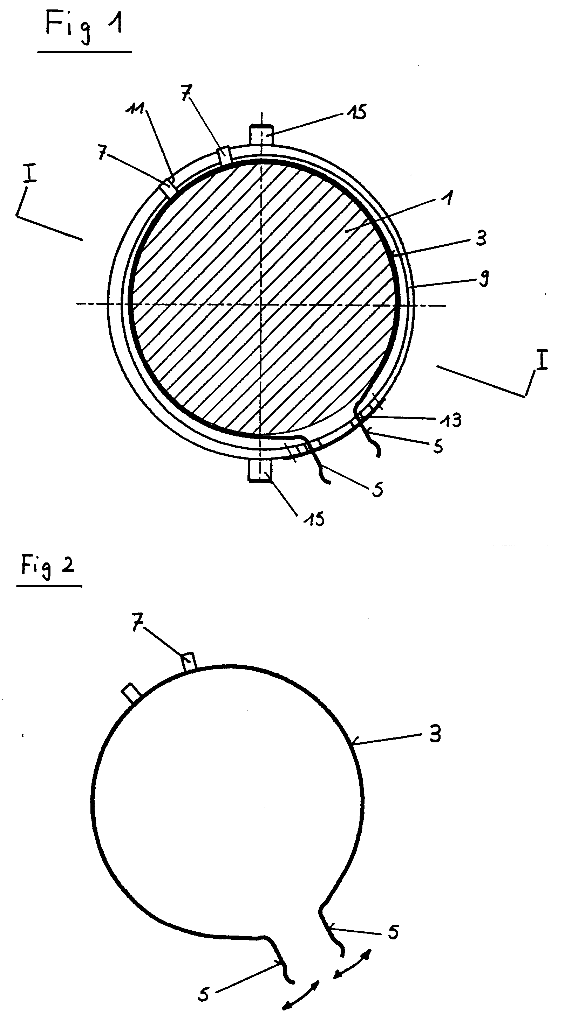

In Fig. 1 ist in Draufsicht eine erfindungsgemässe Substrathaltevorrichtung dargestellt. Dabei handelt es sich um eine Linsenhalterung für das Festhalten einer Linse 1, beispielsweise zum Anordnen in einer Bearbeitungs- bzw. Beschichtungsanlage. Die Linse 1 ist in einer Federspange 3 eingespannt, die einseitig offen ist und auf der offenen Seite je endständig ein Halteelement bzw. Haltegriff 5 umfasst, mittels welchen die Linse, eingespannt in der Federspange 3, gehalten werden kann. Gegenüberliegend zu den Haltegriffen 5 weist die Federspange Lagerzapfen bzw. Abstützungen 7 auf für das Lagern der Federspange in Aufnahmen 11 von einer Halterung bzw. einem Tragring 9.

Für das Lagern bzw. Einrasten der Haltegriffe 5 weist der Tragring weitere Aufnahmen 13 auf, welche im wesentlichen gegenüberliegend zu den Aufnahmen 11 angeordnet sind. Für das Lagern, letztendlich, des Halte- oder Tragringes 9 in einer Bearbeitungsanlage sind radial nach aussen verlaufend Befestigungselemente 15 vorgesehen.

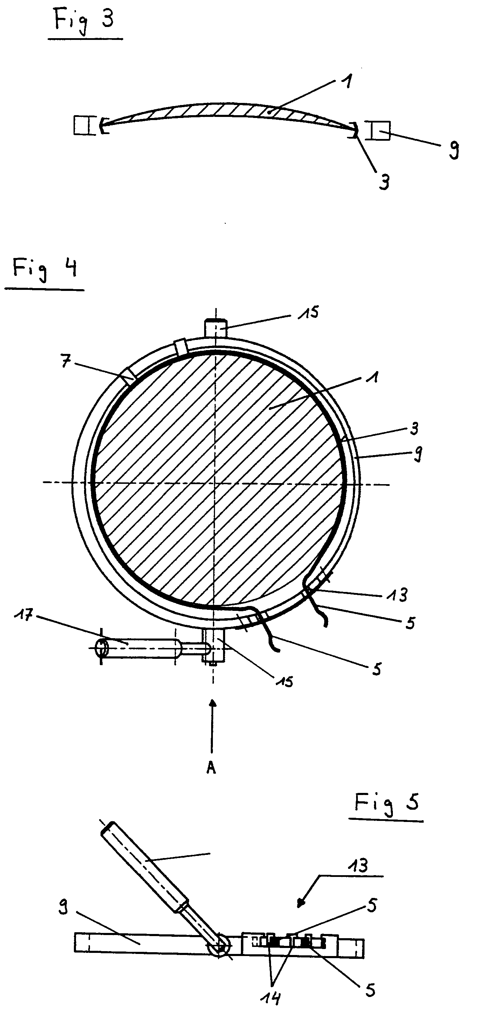

In Fig. 2 ist die Federspange 3 einzeln dargestellt, bereit für die Aufnahme von einer Linse. Wie aus Fig. 2 deutlich erkennbar ist, können mit einer Federspange 3, wie in Fig. 2 dargestellt, Linsen unterschiedlicher Grösse aufgenommen bzw. eingespannt werden. Je nach Grösse der eingespannten Linse werden die Haltegriffe 5 in Pfeilrichtung stärker gegeneinander- oder auseinandergeführt. Das Auswechseln der Linsen kann schnell und auf einfache Art und Weise erfolgen.

Falls eckige, ovale oder anders ausgebildete Substrate einzuspannen sind, kann die Federspange, angepasst an die periphere Kontur des Substrates, entsprechend ausgebildet sein und muss nicht zwingend, wie im dargestellten Beispiel, ringförmig sein.

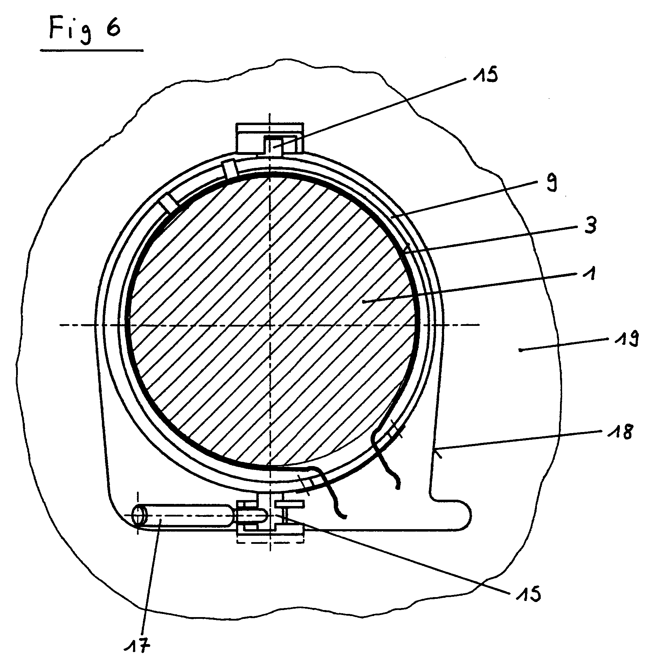

In Fig. 3 ist entlang der Linie I-I aus Fig. 1 ein Schnitt dargestellt, in welchem verdeutlicht wird, dass auch Linsen 1 mit unterschiedlicher Dicke in der Spange angeordnet werden können, wobei vorteilhaft eine gewölbte bzw. den Substratrand übergreifende Wandung der Federspange verwendet werden kann. Ein weiterer Vorteil der den Substratrand übergreifenden Konstruktion liegt darin, dass Substrate mit geringer radialer Kraftbeanspruchung im Randbereich gehalten werden können, was insbesondere deshalb vorteilhaft ist, da bekanntlich gewisse Substratmaterialien auf Krafteinwirkung empfindlich sind. Beispielsweise bei Substraten, wie optischen Linsen, bestehend aus Materialien wie Glas oder aus Kunststoff, können durch die schonende Halterung Ausbrüche oder Deformationen vermieden werden.

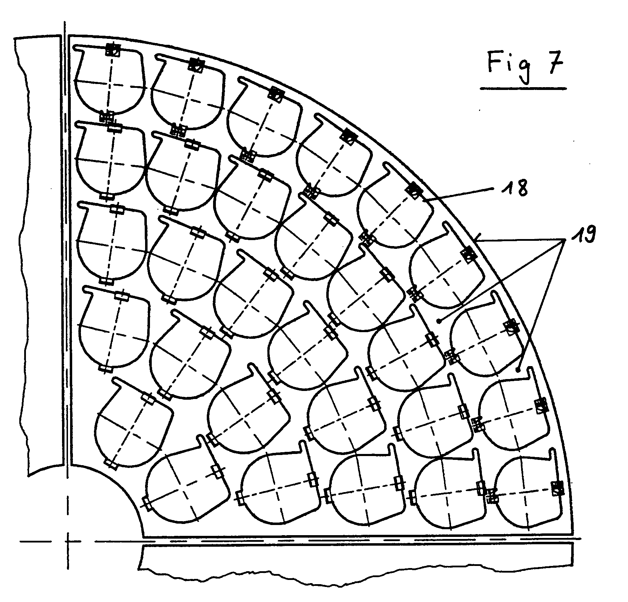

Fig. 4 zeigt erneut, analog Fig. 1, in Obendraufsicht eine erfindungsgemässe Haltevorrichtung für ein Substrat bzw. eine Linse 1, wobei jedoch die Befestigungselemente 15 als Lager für eine Wendevorrichtung ausgebildet sind, weiter umfassend einen Wendehebel 17, damit der Trag- bzw. Haltering beispielsweise um 180° gewendet werden kann. Damit wird es möglich, eine Linse 1 in einer Bearbeitungsanlage nacheinander beidseitig zu bearbeiten bzw. zu beschichten.

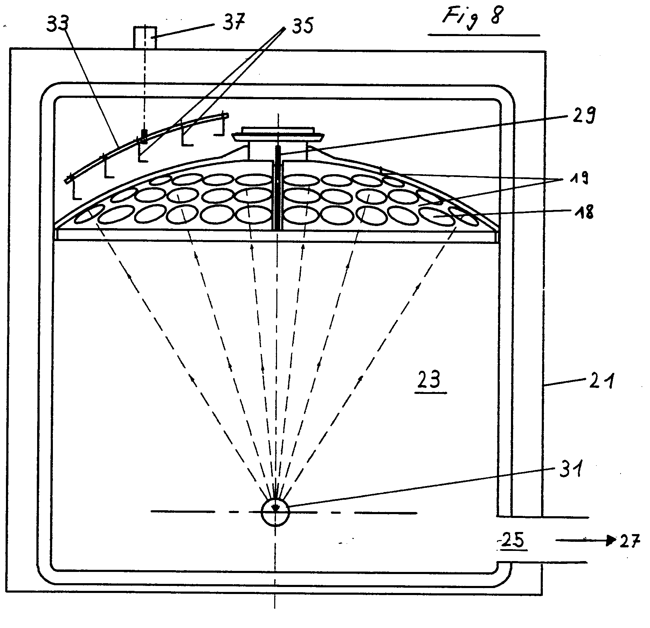

In Fig. 5 ist die Ansicht aus Fig. 4 in Pfeilrichtung A als Seitenansicht dargestellt, insbesondere darstellend die Aufnahme 13 im Trag- bzw. Haltering 9, für das Aufnehmen der beiden Haltegriffe 5 der Federspange 3. Wie aus Fig. 5 erkennbar, weist die weitere Aufnahme 13 verschiedene Einrastpositionen 14 auf, womit die beiden Haltegriffe 5 je nach Grösse der eingespannten Linse 1 in mehreren Positionen je in einer der Aufnahmen 13 eingespannt werden können.

Die in den Fig. 1 bis 5 dargestellte Substrathalterung weist gegenüber den bekannten Halterungen im Stande der Technik wesentliche Vorteile auf, wobei die wichtigsten die nachfolgenden sind:
- Mit wenig Teilen kann eine grosse Palette von verschieden grossen, flächigen Substraten, wie beispielsweise Linsen, Spiegel, Filter und dergleichen, abgedeckt werden, d.h. die erfindungsgemäss definierte Substrathalterung ermöglicht ein hohes Mass an Flexibilität, was besonders wichtig ist bei der Beschichtung von Brillengläsern.
- Einfache Zerlegung der Substrathalterung für Reinigungszwecke.
- Die zu beschichtende Linse wird am Rand minimal abgeschattet, d.h. beispielsweise weniger als 0,5mm.
- Durch die geringe radiale Kraftbeanspruchung im Randbereich ergeben sich keine mechanischen Beschädigungen und Deformationen bei empfindlichen Substraten, wie Linsen. Insbesondere bei Kunststofflinsen kann bei thermischer Belastung ein schädliches Deformieren der Substrate vermieden werden.
- Mit derselben Federspange können verschiedene Linsendurchmesser und verschiedene Linsenstärken mit derselben Substrathalterung eingespannt werden; und
- geringe Chargierzeit sowie zuverlässige und reproduzierbare Arbeitsweise.

Die in den Fig. 1 bis 5 dargestellten Substrathalterungen eignen sich speziell für das Einspannen und Lagern von Substraten, wie Linsen, in Vakuumbeschichtungsanlagen, worauf, unter Bezugnahme auf die Fig. 6 und 7, näher eingegangen wird.

Fig. 6 zeigt einen Ausschnitt aus einem Halteorgan 19 mit einem erfindungsgemäss definierten Substrathalter, analog demjenigen von Fig. 4, wobei das Halteorgan 19 dazu vorgesehen und geeignet ist, mehrere derartige Substrathalter zu umfassen. Beim flächigen Halteorgan 19 kann es sich beispielsweise um einen Träger in Platten- oder Kalottenform handeln, in oder auf welchem mehrere Substrathalter der beschriebenen Art angeordnet sind für das Aufnehmen und Beschichten von Substraten, wie beispielsweise Linsen. Im Halteorgan 19 ist eine Oeffnung 18 vorgesehen, in welcher die erfindungsgemässe Substrathalterung angeordnet ist, drehbar gelagert mit den beiden Befestigungselementen 15 in entsprechenden Aufnahmen an der Halterung 19.

Auf die Beschreibung der Substrathalterung wird an dieser Stelle verzichtet und auf Fig. 4 verwiesen.

In der dargestellten Substrathalterung ist eine Linse 1, in der Federspange 3 eingespannt, angeordnet, um, in der Halterung 19 angeordnet, in einer Vakuumanlage beschichtet zu werden. Wenn nun die Linse 1 einseitig beschichtet worden ist, kann sie, eingespannt in der Substrathalterung, mittels des Hebels 17 um die beiden Befestigungselemente 15 um 180° gedreht werden, da ja infolge der Oeffnung 18 die Substrathalterung in der Trägerplatte 19 frei drehbar ist. Nach erfolgter Rotation der Substrathalterung um 180° kann die Linse ebenfalls an ihrer Rückseite beschichtet werden. Der Vorteil des geschilderten Wendevorganges liegt darin, dass die Beschichtung der Rückseite ohne langen Unterbruch des Bearbeitungsprozesses und ohne Oeffnen der Anlage erfolgen kann.

In Fig. 7 ist nun ein ganzes Segment eines plattenförmigen Halteorgans 19 dargestellt, umfassend eine ganze Anzahl von Oeffnungen 18, vorgesehen für das Anordnen von erfindungsgemäss beschriebenen Substrathalterungen. Aus Fig. 7 wird deutlich, dass gleichzeitig in demselben Halteorgan 19 mehrere Linsen beschichtet werden können und dass mittels des oben geschilderten Wendevorganges die Beschichtung der Linsen beidseitig erfolgen kann. Für das Wenden der einzelnen Linsen können entweder individuell für jede Substrathalterung eine eigene Wendevorrichtung vorgesehen sein, oder aber die Trägerplatte kann um eine zentrale Achse gedreht werden, wobei je einer des in Fig. 6 dargestellten Wendehebels 17 von jeder Substrathalterung gegen einen eingeschwenkten Anschlag läuft, wodurch die Substrate auf einfache Art gewendet werden. Auf einen derartigen Einschwenkmechanismus wird unter Bezug auf Fig. 8 näher eingegangen.

Beim geschilderten Halteorgan 19 kann es sich entweder um eine plane Platte handeln oder aber auch um eine gewölbte Fläche. In jedem Falle ist es wesentlich, dass die Substrathalter in derselben Fläche liegend angeordnet sind. Die Wahl einer entsprechenden Flächenwölbung hängt in bekannter Weise von der Dimensionierung der Aufdampfanordnung ab.

Im Gegensatz zum planen Halteorgan 19 von Fig. 7 zeigt Fig. 8 ein kalottenartiges Halteorgan 19, angeordnet in einer Vakuumkammer 23 von einer Aufdampfanlage 21. Die Aufdampfanlage 21 ist dabei in Seitenansicht von vorne dargestellt, mit entfernter Frontöffnung, damit der kalottenartige Substrathalter 19 sichtbar ist. Schematisch dargestellt, umfasst die Aufdampfanlage 21 eine Auslassöffnung 25, welche beispielsweise zu einer Vakuumpumpe 27 führt, mittels welcher der Bearbeitungsraum 23 evakuiert werden kann.

Das kalottenartige Halteorgan 19 umfasst in den Oeffnungen 18 erfindungsgemäss die einzelnen Substrathalterungen, auf deren Darstellung aus Uebersichtlichkeitsgründen verzichtet worden ist. Das Halteorgan 19 ist weiter um eine Achse 29 frei drehbar gelagert angeordnet, damit die Kalotte während des Aufdampfens von einer Verdampfungsquelle 31 mittels eines Antriebes gedreht werden kann. Diese Methode des Rotierens mit einem Antrieb um eine Zentralachse ist insbesondere vorteilhaft, um eine homogene Schichtdickenverteilung bei dem Beschichtungsvorgang sicherstellen zu können. Bei der Verdampfungsquelle 31 kann es sich dabei beispielsweise um eine Elektronenstrahl-Verdampfungsouelle handeln.

Wenn nun die in den Oeffnungen 18 angeordneten optischen Substrate, wie beispielsweise Linsen, Spiegel, Filter und dergleichen, einseitig beschichtet sind, wird ein Einschwenkmechanismus 33 zum Wenden der einzelnen Substrathalter mittels eines Ansenkmechanismus 37 gegen das kalottenartige Halteorgan 19 abgesenkt. Wenn der Einschwenkmechanismus 33 ausreichend abgesenkt ist, greifen die einzelnen Wendehaken 35 an den Wendehebeln 17 der einzelnen Substrathalterungen ein, und durch Drehen des Halteorganes 19 um 360° werden sämtliche Substrathalter um 180° gewendet.

Nach der Wendeoperation wird der Einschwenkmechanismus 33 durch den Absenkmechanismus 37 wieder zurückgezogen, und der Beschichtungsvorgang in der Aufdampfanlage kann seine Fortsetzung finden. Dabei ist es vorteilhaft, wenn derselbe Antrieb für die Drehbewegung des kalottenartigen Halteorganes 19 ebenfalls für den Antrieb des Absenkmechanismus 37 verwendet wird.

Bei den in den Fig. 1 bis 8 dargestellten Ausführungen handelt es sich um Beispiele, die ausschliesslich dazu dienen sollen, die Erfindung näher zu erläutern. Selbstverständlich ist es möglich, die dargestellten Ausführungen auf x-beliebige Art und Weise zu modifizieren bzw. abzuändern; so ist es inbesondere beispielsweise möglich, die Abstützung der Federspange 3 in einem Halte- oder Tragring 9 anders auszugestalten. Auch muss nicht zwingend ein Haltering 9 vorgesehen werden, und die für das Abstützen der Federspange 3 verwendete Halterung kann beispielsweise auch eckig, wie viereckig bzw. rechteckig oder oval sein oder auf irgendeine andere Art und Weise ausgestaltet sein.

Erfindungswesentlich ist die Verwendung einer erfindungsgemäss definierten Federspange, die zusammen mit einem einzuspannenden Substrat in einer Halterung gelagert werden kann, beispielsweise für das Einbringen in eine Vakuumbearbeitungsanlage.

## Patentansprüche

1. Vorrichtung zum Halten von im wesentlichen flachen Substraten, wie beispielsweise Linsen, mit unterschiedlicher Grösse für das Anordnen in einer Vakuumbearbeitungsanlage, gekennzeichnet durch
- eine äussere, im wesentlichen starre Halterung (9) und
- eine in die Halterung (9) einlegbare Federspange (3) für das Substrat (1).

2. Vorrichtung, vorzugsweise nach mindestens einem der Ansprüche, wie nach Anspruch 1, dadurch gekennzeichnet, dass die Spange (3) vorgesehen ist für das im wesentlichen umgreifend einfassende Halten des flachen Substrates (1) und entsprechend der peripheren Kontur des Substrates beispielsweise eckig, oval oder wenigstens nahezu kreisrund ausgebildet ist mit an je einem Spangenende einem Halteelement (5) für das Einspannen des Substrates.

3. Vorrichtung, vorzugsweise nach mindestens einem der Ansprüche, wie nach Anspruch 2, dadurch gekennzeichnet, dass an der Federspange (3) mindestens ein im wesentlichen nach aussen gerichtetes Lagerelement (7) vorgesehen ist, um die Spange zusammen mit dem oder den Halteelement(en) in der Halterung (9) in oder an entsprechenden Aufnahmen (11, 13) zu lagern.

4. Vorrichtung, vorzugsweise nach mindestens einem der Ansprüche, wie nach einem der Ansprüche 1 bis 3, dadurch gekennzeichnet, dass die Federspange (3) im wesentlichen ringförmig ausgebildet ist für das Einspannen von im wesentlichen kreisrunden, flächigen Substraten (1), wie beispielsweise von Linsen in der Halterung bzw. in einem Tragring (9).

5. Vorrichtung, vorzugsweise nach mindestens einem der Ansprüche, wie nach einem der Ansprüche 3 oder 4, dadurch gekennzeichnet, dass die Aufnahme(n) (13), vorgesehen in der Halterung (9) für das Lagern der Haltegriffe (5) der Spange (3), mehrere Einrastpositionen (14) umfasst (umfassen), um die Federspange (3) unterschiedlich zu spannen bzw. um unterschiedliche Substratgrössen in der Federspange einzuspannen.

6. Vorrichtung, vorzugsweise nach mindestens einem der Ansprüche, wie nach einem der Ansprüche 1 bis 5, dadurch gekennzeichnet, dass die Innenseite der Federspange (3) mindestens teilweise den Substratrand übergreifend ausgebildet ist, wie beispielsweise gewölbt bzw. konkav, um ein Einspannen von Substraten mit unterschiedlicher Dicke bzw. um ein Halten von Substraten mit geringer radialer Kraftbeanspruchung im Randbereich zu ermöglichen.

7. Vorrichtung, vorzugsweise nach mindestens einem der Ansprüche, wie nach einem der Ansprüche 2 bis 6, dadurch gekennzeichnet, dass die Halteelemente radial von der Federspange nach aussen gerichtete Haltegriffe (5) sind.

8. Vorrichtung, vorzugsweise nach mindestens einem der Ansprüche, wie nach einem der Ansprüche 1 bis 7, dadurch gekennzeichnet, dass die Halterung (9) mindestens ein Befestigungselement (15) aufweist für das Anordnen in einer Bearbeitungsanlage.

9. Vorrichtung, vorzugsweise nach mindestens einem der Ansprüche, wie nach Anspruch 8, dadurch gekennzeichnet, dass vorzugsweise zwei sich gegenüberliegende Befestigungselemente (15) vorgesehen sind, die als Drehlager für die Halterung bzw. den Tragring (9) ausgebildet sind, wie beispielsweise als Lager für eine Wendevorrichtung.

10. Vorrichtung, vorzugsweise nach mindestens einem der Ansprüche, wie nach einem der Ansprüche 8 oder 9, dadurch gekennzeichnet, dass ein Betätigungselement (17), wie beispielsweise ein hebelartiges Organ, vorgesehen ist für das Wenden der Halterung (9).

11. Mehrfachsubstrathalterung mit einer Vorrichtung, vorzugsweise nach mindestens einem der Ansprüche, wie nach einem der Ansprüche 1 bis 10, dadurch gekennzeichnet, dass mindestens zwei Halterungen bzw. Tragringe (9) in oder auf einem Halteorgan (19), im wesentlichen in derselben Fläche liegend, angeordnet sind.

12. Mehrfachsubstrathalterung, vorzugsweise nach mindestens einem der Ansprüche, wie nach Anspruch 11, dadurch gekennzeichnet, dass das flächige Halteorgan (19) eine Vielzahl von Halterungen (9) umfasst, die je einzeln um eine individuelle Achse und/oder gemeinsam um eine Zentralachse des Halteorganes rotierbar sind.
